# EUROPÄISCHE PATENTANMELDUNG

(11) **EP 4 480 743 A1**
(43) Veröffentlichungstag der Anmeldung: **25.12.2024**
(21) Anmeldenummer: 24180549.8
(22) Anmeldetag: 06.06.2024
(51) Int. Cl.: B60L 58/16, H02M 1/32

(54) **VERFAHREN ZUM BETREIBEN MINDESTENS EINES LEISTUNGSELEKTRONISCHEN BAUTEILS UND LEISTUNGSELEKTRONISCHE ANORDNUNG**

(30) Priorität: 16.06.2023 DE 102023205669
(71) Anmelder: VOLKSWAGEN AG, 38440 Wolfsburg (DE)
(72) Erfinder: Maznov, Viktor, 34298 Eschenstruth (DE); Arnaout, Samy, Tianjin, 300040 (CN); Dedeleit, Lukas, 34121 Kassel (DE)

(57) **Zusammenfassung**

Die Erfindung betrifft ein Verfahren zum Betreiben mindestens eines leistungselektronischen Bauteils (2), wobei ausgehend von Betriebsparametern (10,10-x) und/oder Bauteilparametern (11) und einem Lebensdauermodell (20) des mindestens einen leistungselektronischen Bauteils (2) ein Ist-Gesundheitszustand (30) des mindestens einen leistungselektronischen Bauteils (2) bestimmt wird, wobei ausgehend von einer Betriebsdauer (12) und/oder einer Laufleistung (13) des mindestens einen leistungselektronischen Bauteils (2) ein Soll-Gesundheitszustand (31) des mindestens einen leistungselektronischen Bauteils (2) bestimmt wird, wobei der bestimmte Ist-Gesundheitszustand (30) mit dem bestimmten Soll-Gesundheitszustand (31) verglichen wird, und wobei eine Ansteuerung des mindestens einen leistungselektronischen Bauteils (2) unter Berücksichtigung eines Vergleichsergebnisses (32) erfolgt. Ferner betrifft die Erfindung ein leistungselektronisches Bauteil (2).

## Beschreibung

Die Erfindung betrifft ein Verfahren zum Betreiben mindestens eines leistungselektronischen Bauteils und eine leistungselektronische Anordnung.

Leistungselektronische Bauteile, insbesondere Leistungshalbleiter, werden zum Erreichen von Lebensdaueranforderungen in Fahrzeugen, aber auch auf anderen Anwendungsgebieten, in der Regel überdimensioniert ausgelegt. Dies führt zu hohen Kosten. Wird auf eine Überdimensionierung als Sicherheitsmarge verzichtet, so kann dies zu einer geringeren Lebensdauer führen. Daher besteht ein Zielkonflikt zwischen einer vorgegebenen Lebensdauer und Kostenanforderungen.

Aus der DE 10 2014 227 027 A1 ist ein intelligentes Leistungsbauteil mit parallel zueinander ausgerichteten Platten bekannt, welche mit den Stromeingängen und den Stromausgängen von Leistungshalbleitern verbunden sind. Damit können hohe Ströme, beispielsweise zum Widerstandsschweißen, gesteuert werden, ohne dass übermäßig viel Verlustwärme entsteht. Ferner ist eine Lebensdauerüberwachung bekannt.

Der Erfindung liegt die Aufgabe zu Grunde, ein Verfahren zum Betreiben mindestens eines leistungselektronischen Bauteils und eine leistungselektronische Anordnung, insbesondere im Hinblick auf den vorgenannten Zielkonflikt, zu verbessern.

Die Aufgabe wird erfindungsgemäß durch ein Verfahren mit den Merkmalen des Patentanspruchs 1 und eine leistungselektronische Anordnung mit den Merkmalen des Patentanspruchs 10 gelöst. Vorteilhafte Ausgestaltungen der Erfindung ergeben sich aus den Unteransprüchen.

Insbesondere wird ein Verfahren zum Betreiben mindestens eines leistungselektronischen Bauteils zur Verfügung gestellt, wobei ausgehend von Betriebs- und/oder Bauteilparametern und einem Lebensdauermodell des mindestens einen leistungselektronischen Bauteils ein Ist-Gesundheitszustand des mindestens einen leistungselektronischen Bauteils bestimmt wird, wobei ausgehend von einer Betriebsdauer und/oder einer Laufleistung des mindestens einen leistungselektronischen Bauteils ein Soll-Gesundheitszustand des mindestens einen leistungselektronischen Bauteils bestimmt wird, wobei der bestimmte Ist-Gesundheitszustand mit dem bestimmten Soll-Gesundheitszustand verglichen wird, und wobei eine Ansteuerung des mindestens einen leistungselektronischen Bauteils unter Berücksichtigung eines Vergleichsergebnisses erfolgt.

Ferner wird insbesondere eine leistungselektronische Anordnung geschaffen, umfassend mindestens ein leistungselektronisches Bauteil und eine Steuereinrichtung, die eingerichtet ist zum Ansteuern des mindestens einen leistungselektronischen Bauteils, wobei die Steuereinrichtung ferner dazu eingerichtet ist, ausgehend von Betriebs- und/oder Bauteilparametern und einem Lebensdauermodell des mindestens einen leistungselektronischen Bauteils einen Ist-Gesundheitszustand des mindestens einen leistungselektronischen Bauteils zu bestimmen, ausgehend von einer Betriebsdauer und/oder einer Laufleistung des mindestens einen leistungselektronischen Bauteils einen Soll-Gesundheitszustand des mindestens einen leistungselektronischen Bauteils zu bestimmen, den bestimmten Ist-Gesundheitszustand mit dem bestimmten Soll-Gesundheitszustand zu vergleichen, und die Ansteuerung des mindestens einen leistungselektronischen Bauteils unter Berücksichtigung eines Vergleichsergebnisses durchzuführen.

Das Verfahren und die leistungselektronische Anordnung ermöglichen es, eine Ansteuerung des mindestens einen leistungselektronischen Bauteils unter Berücksichtigung eines Ist-Gesundheitszustands und eines Soll-Gesundheitszustands des mindestens einen leistungselektronischen Bauteils vorzunehmen. Dies ermöglicht es, ein individuelles Verhalten und individuelle Betriebs- und Bauteilparameter des mindestens einen leistungselektronischen Bauteils bei der Ansteuerung derart zu berücksichtigen, das ein Alterungsprozess in kontrollierter Weise erfolgen kann. Hierzu wird ausgehend von Betriebs- und/oder Bauteilparametern und einem Lebensdauermodell des mindestens einen leistungselektronischen Bauteils ein Ist-Gesundheitszustand des mindestens einen leistungselektronischen Bauteils bestimmt. Dieser Ist-Gesundheitszustand ist insbesondere eine Schätzung für den realen Alterungszustand des leistungselektronischen Bauteils, bei dem eine Historie der bauteilindividuellen Belastung mit einfließt. Ferner wird ausgehend von einer (kumulierten) Betriebsdauer und/oder einer (kumulierten) Laufleistung des mindestens einen leistungselektronischen Bauteils ein Soll-Gesundheitszustand des mindestens einen leistungselektronischen Bauteils bestimmt. Der Soll-Gesundheitszustand entspricht hierbei insbesondere einem von der Betriebsdauer und/oder der Laufleistung abhängigen erwarteten Gesundheitszustand, welcher mit einer erwarteten Alterung korrespondiert, ohne dass hierbei eine Historie der bauteilindividuellen Belastung berücksichtigt wird. Der bestimmte Ist-Gesundheitszustand wird mit dem bestimmten Soll-Gesundheitszustand verglichen. Die Ansteuerung des mindestens einen leistungselektronischen Bauteils erfolgt dann unter Berücksichtigung eines Vergleichsergebnisses.

Einer der Vorteile des Verfahrens und der leistungselektronischen Anordnung ist, dass der eingangs beschriebene Zielkonflikt verbessert gehandhabt werden kann. Insbesondere kann auf eine vorbeugende Überdimensionierung des mindestens einen leistungselektronischen Bauteils verzichtet werden, da mittels des Verfahrens und der leistungselektronischen Anordnung fortlaufend eine Abstimmung zwischen einer Lebensdauer und einer Leistungsfähigkeit des mindestens einen leistungselektronischen Bauteils erfolgen kann.

Ein Gesundheitszustand wird im Rahmen dieser Offenbarung als besser oder größer angesehen, wenn ein dem Gesundheitszustand zugeordneter Zahlenwert größer ist. Grundsätzlich kann in analoger Weise jedoch auch eine umgekehrte Kodierung bzw. Abbildung des Gesundheitszustands erfolgen.

Ein leistungselektronischen Bauteil ist insbesondere ein Leistungshalbleiterschalter (z.B. ein MOSFET oder ein IGBT). Grundsätzlich kann ein leistungselektronisches Bauteil aber auch ein anderes ansteuerbares leistungselektronisches Bauteil sein. Die leistungselektronische Anordnung kann auch eine Mehrzahl von leistungselektronischen Bauteilen umfassen. Die leistungselektronische Anordnung kann beispielsweise einen Stromrichter umfassen, beispielsweise einen Pulswechselrichter, der beispielsweise in einem Antriebsstrang eines Fahrzeugs zum Speisen einer elektrischen Maschine eingesetzt wird. Grundsätzlich können die leistungselektronische Anordnung und das Verfahren aber auch auf anderen Anwendungsgebieten eingesetzt werden. Bei einer Mehrzahl von leistungselektronischen Bauteilen, die miteinander zusammenwirken, erfolgt die Ansteuerung hierbei insbesondere derart, dass der von allen kritischste Ist-Gesundheitszustand (d.h. derjenige mit dem geringsten Wert) der Mehrzahl der leistungselektronischen Bauteile maßgebend ist.

Es ist insbesondere vorgesehen, dass die Betriebs- und/oder Bauteilparameter mittels einer geeigneten Sensorik erfasst und/oder bestimmt werden. Die Betriebsparameter können beispielsweise eine Gleichspannung, einen Gleichstrom, eine Wechselspannung, einen Wechselstrom, einen Fehlerzustand und/oder eine Bauteiltemperatur (eine Chiptemperatur, eine Kühlwassertemperatur etc.) umfassen. Die Bauteilparameter können beispielsweise eine Schwellenspannung (Thresholdspannung), eine Schwellenspannungsdrift, einen Durchlasswiderstand (zwischen Source und Drain im Durchlasszustand) und/oder einen Leckstrom (zwischen Source und Drain und/oder zwischen Source und Gate) umfassen.

Das Lebensdauermodell basiert insbesondere auf an sich bekannten Verfahren, mittels denen ein Gesundheitszustand (bzw. ein Alterungszustand) eines leistungselektronischen Bauteils bestimmt, insbesondere geschätzt, werden kann. Hierzu wird insbesondere auch ein historischer Verlauf der Betriebs- und/oder Bauteilparameter berücksichtigt. Beispielsweise kann ein solcher historischer Verlauf Temperaturschwankungen in den Betriebsparametern berücksichtigen und/oder eine Belastung (Ströme, Spannungen, Leistungen, Schaltfrequenz, Schaltflankensteilheit etc.) des leistungselektronischen Bauteils im historischen Verlauf. Ausgehend von den erfassten und/oder bestimmten Betriebs- und/oder Bauteilparametern schätzt das Lebensdauermodell den Ist-Gesundheitszustand des mindestens einen leistungselektronischen Bauteils. Das Lebensdauermodell kann insbesondere anhand von empirischen Versuchen und/oder mit Hilfe von Simulationen erstellt werden oder erstellt worden sein.

Unabhängig von einer Historie der Belastung wird ferner ausgehend von einer (kumulierten) Betriebsdauer (z.B. kumulierte Betriebsstunden) und/oder einer Laufleistung (z.B. kumulierte Kilometer eines Antriebsstrangs eines Fahrzeugs, in dem das mindestens eine leistungselektronische Bauteil betrieben wird) des mindestens einen leistungselektronischen Bauteils ein Soll-Gesundheitszustand bestimmt. Dieser Soll-Gesundheitszustand basiert hierbei auf empirisch und/oder durch Simulation und insbesondere statistisch ermittelten Kennlinien und/oder Kennfeldern, welche einen über eine Vielzahl von gleichartigen leistungselektronischen Bauteilen gemittelten Gesundheitszustand des leistungselektronischen Bauteils in Abhängigkeit von der Betriebsdauer und/oder der Laufleistung zeigen. Die Kennlinien und/oder Kennfelder werden hierbei unter Laborbedingungen erzeugt, beispielsweise mit Hilfe von an sich bekannten Verfahren für beschleunigte Alterungstests.

Die Ansteuerung des mindestens einen leistungselektronischen Bauteils betrifft insbesondere Werte für eine Gatespannung (minimaler Wert, maximaler Wert), Gateansteuerparameter (z.B. eine Schaltgeschwindigkeit bzw. eine Flankensteilheit), eine Schaltfrequenz, Schaltmuster und/oder Steuerparameter des Kühlsystems (z.B. einen Kühlwasserdurchfluss und/oder eine Kühlleistung und/oder eine Kühlmitteltemperatur).

Teile der leistungselektronischen Anordnung, insbesondere die Steuereinrichtung, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) und/oder feldprogrammierbares Gatterfeld (FPGA) ausgebildet sind.

In einer Ausführungsform ist vorgesehen, dass die Ansteuerung des mindestens einen leistungselektronischen Bauteils in dem Fall, in dem ein Wert des bestimmten Ist-Gesundheitszustands kleiner ist als ein Wert des bestimmten Soll-Gesundheitszustands, derart geändert wird, dass eine Leistungsfähigkeit des mindestens einen leistungselektronischen Bauteils zugunsten einer Lebensdauer verringert wird. Hierdurch kann das mindestens eine leistungselektronische Bauteil nachfolgend derart angesteuert werden, dass der Ist-Gesundheitszustand sich wieder dem Soll-Gesundheitszustand annähert. Insbesondere kann hierdurch eine verbleibende Lebensdauer wieder erhöht werden, da das mindestens eine leistungselektronische Bauteil mit einer geringeren Leistungsfähigkeit betrieben wird, sodass eine Belastung verringert ist und eine Bauteilalterung langsamer auftritt. Beispielsweise kann auf Kosten eines (System-)Wirkungsgrades eine Schaltfrequenz verringert werden, sodass im selben Zeitraum weniger oft geschaltet wird. Ferner kann auf Kosten des (System-)Wirkungsgrades eine Gatespannung für den Durchlasszustand verringert werden. Weiter kann durch Ändern der Ansteuerung auch ein maximaler Leistungsfluss durch das leistungselektronische Bauteil reduziert werden.

In einer Ausführungsform ist vorgesehen, dass die Ansteuerung des mindestens einen leistungselektronischen Bauteils in dem Fall, in dem ein Wert des bestimmten Ist-Gesundheitszustands größer als ein Wert des bestimmten Soll-Gesundheitszustands ist, derart geändert wird, dass eine Leistungsfähigkeit des mindestens einen leistungselektronischen Bauteils erhöht wird. Hierdurch kann das mindestens eine leistungselektronische Bauteil nachfolgend derart angesteuert werden, dass der Ist-Gesundheitszustand sich wieder dem Soll-Gesundheitszustand annähert, wobei eine größere Leistungsfähigkeit des mindestens einen leistungselektronischen Bauteils bereitgestellt werden kann. Anders ausgedrückt kann hierdurch eine Lebensdauerreserve bzw. ein Lebensdauerüberschuss verringert werden, um das mindestens eine leistungselektronische Bauteil hierfür mit einer größeren Leistungsfähigkeit zu betreiben. Beispielsweise kann zu Gunsten eines (System-)Wirkungsgrades eine Schaltfrequenz erhöht werden, sodass im selben Zeitraum öfter geschaltet wird. Ferner kann zu Gunsten des (System-)Wirkungsgrades eine Gatespannung für den Durchlasszustand erhöht werden. Weiter kann durch Ändern der Ansteuerung auch ein maximaler Leistungsfluss durch das leistungselektronische Bauteil erhöht werden.

In einer Ausführungsform ist vorgesehen, dass das Verringern und/oder Erhöhen der Leistungsfähigkeit unter Berücksichtigung einer vorgegebenen Ziellebensdauer erfolgt. Hierdurch kann eine Art Regelung über die Leistungsfähigkeit des mindestens einen leistungselektronischen Bauteils erfolgen, bei der der Ist-Gesundheitszustand stets auf den Soll-Gesundheitszustand gebracht wird, um die vorgegebene Ziellebensdauer zu erreichen. Insbesondere ist der Soll-Gesundheitszustand hierbei derart gewählt, dass eine Entwicklung des Soll-Gesundheitszustands mit der vorgegebenen Ziellebensdauer korrespondiert bzw. diese erfüllt. Die Ziellebensdauer ist hierbei insbesondere eine Mindestlebensdauer des mindestens einen leistungselektronischen Bauteils. Die Ziellebensdauer kann hierbei insbesondere eine Betriebsdauer (z.B. Anzahl von Betriebsstunden) oder eine Laufleistung (z.B. in Kilometern, wenn das mindestens eine leistungselektronische Bauteil in einem Antriebsstrang eines Fahrzeugs verbaut ist) umfassen.

In einer Ausführungsform ist vorgesehen, dass das Verringern und/oder Erhöhen der Leistungsfähigkeit unter Berücksichtigung eines Fahrverhaltens mindestens eines Fahrers eines Fahrzeugs erfolgt, in dem das mindestens eine leistungselektronische Bauteil verbaut ist. Hierdurch kann das Fahrverhalten berücksichtigt werden. Insbesondere kann ausgehend von dem Fahrverhalten eine zukünftige Belastung des mindestens einen leistungselektronischen Bauteils geschätzt und bei der Ansteuerung berücksichtigt werden. Ist ein Fahrverhalten eines Fahrers beispielsweise sportlich, so geht dieses Fahrverhalten in der Regel mit erhöhten Leistungsanforderungen einher, was zu einer größeren Belastung und schnelleren Alterung des mindestens einen leistungselektronischen Bauteils führt. Wird das Fahrzeug jedoch nur selten gefahren, so hat ein solches sportliches Fahrverhalten keinen negativen Einfluss auf den Ist-Gesundheitszustand im Vergleich zum Soll-Gesundheitszustand. Anders ausgedrückt liegt der Ist-Gesundheitszustand bei ausreichend seltenem sportlichen Fahren immer noch über dem Soll-Gesundheitszustand. Wird das Fahrzeug jedoch öfters oder immer mit einem sportlichen Fahrverhalten gefahren, so altert das mindestens eine leistungselektronische Bauteil schneller und der Ist-Gesundheitszustand wird unter den erwarteten Soll-Gesundheitszustand absinken. Daher wird ausgehend von diesem Fahrverhalten des Fahrers die Ansteuerung derart angepasst, dass eine Leistungsfähigkeit des mindestens einen leistungselektronischen Bauteils reduziert ist.

In einer Ausführungsform ist vorgesehen, dass mindestens ein Parameter einer zum Kühlen des mindestens einen leistungselektronischen Bauteils eingerichteten Kühleinrichtung unter Berücksichtigung des Vergleichsergebnisses festgelegt und/oder gewählt wird. Hierdurch können Betriebsbedingungen in Bezug auf eine Betriebstemperatur des mindestens einen leistungselektronischen Bauteils angepasst werden. Der mindestens eine Parameter kann beispielsweise eine Kühlmitteltemperatur und/oder ein Kühlmitteldurchfluss sein. Dies ist insbesondere von Vorteil, wenn festgestellt wird, dass das mindestens eine leistungselektronische Bauteil eine große Anzahl von Temperaturwechseln erfährt. Diese können eine Alterung beschleunigen. Durch eine stärkere Kühlung kann dem entgegengewirkt werden, allerdings auf Kosten eines (System-)Wirkungsgrades.

In einer Ausführungsform ist vorgesehen, dass mindestens ein Bauteilparameter des mindestens einen leistungselektronischen Bauteils bei einer ersten Inbetriebnahme erfasst und/oder bestimmt wird, wobei die Ansteuerung des mindestens einen leistungselektronischen Bauteils unter Berücksichtigung einer im weiteren Betrieb auftretenden Parameterdrift des mindestens einen erfassten und/oder bestimmten Bauteilparameters erfolgt. Hierdurch kann die Ansteuerung derart erfolgen, dass die Parameterdrift kompensiert wird. Beispielsweise kann eine Thesholdspannung bestimmt werden und die Ansteuerung entsprechend einer Drift der Thresholdspannung erfolgen. Ferner kann bei Feststellen einer Drift der Thresholdspannung auch eine Ansteuerfrequenz reduziert werden, um eine fortgeschrittene Alterung zu berücksichtigen.

In einer Ausführungsform ist vorgesehen, dass mindestens ein Bauteilparameter des mindestens einen leistungselektronischen Bauteils bei einer ersten Inbetriebnahme erfasst und/oder bestimmt wird, wobei die Ansteuerung des mindestens einen leistungselektronischen Bauteils zur Kompensation einer Parameterstreuung unter Berücksichtigung des mindestens einen erfassten und/oder bestimmten Bauteilparameters erfolgt. Hierdurch kann ein aufgrund einer Parameterstreuung auftretendes Verhalten des mindestens einen leistungselektronischen Bauteils angepasst werden, indem die Ansteuerung unter Berücksichtigung des mindestens einen erfassten und/oder bestimmten Bauteilparameters erfolgt. Eine auftretende Parameterstreuung kann hierdurch kompensiert werden, sodass das Verhalten einem vorgegebenen Soll-Verhalten entspricht. Beispielsweise kann eine Gatespannung (Durchlass und/oder Sperren) in Abhängigkeit von dem mindestens einen erfassten und/oder bestimmten Bauteilparameter gesetzt werden, sodass ein Schaltverhalten an ein Soll-Schaltverhalten angepasst ist. Hierbei kann auch ein Referenzwert für den mindestens einen Bauteilparameter berücksichtigt werden, der mit dem Soll-Verhalten einhergeht.

In einer Ausführungsform ist vorgesehen, dass die Betriebsparameter eine Umgebungstemperatur und/oder eine Höhenstrahlungsbelastung und/oder eine Betriebshöhe umfassen und/oder dass die Umgebungstemperatur und/oder die Höhenstrahlungsbelastung und/oder die Betriebshöhe im Lebensdauermodell berücksichtigt werden. Hierdurch können insbesondere Umweltbedingungen, unter denen das mindestens eine leistungselektronische Bauteil betrieben wird, berücksichtigt werden. Hierdurch kann insbesondere berücksichtigt werden, ob ein Betrieb in einer heißen Region, einer kalten Region oder einer Region mit gemäßigten Temperaturen erfolgt. Ferner kann hierdurch insbesondere eine durch Höhenstrahlung hervorgerufene Beeinträchtigung berücksichtigt werden, welche in Leistungshalbleitern zu einer beschleunigten Alterung führt. Wird beispielsweise festgestellt, dass eine Umgebungstemperatur immer oder regelmäßig über einem vorgegebenen Schwellwert liegt, so kann die Ansteuerung entsprechend angepasst werden, indem eine Leistungsfähigkeit des mindestens einen leistungselektronischen Bauteils reduziert wird, um dieses zu schonen und die durch die Umgebungstemperatur hervorgerufene beschleunigte Alterung zu kompensieren. Wird beispielsweise festgestellt, dass die Höhenstrahlungsbelastung und/oder eine Betriebshöhe immer oder regelmäßig über einem vorgegebenen Schwellwert liegen, so kann das Ansteuern entsprechend angepasst werden, indem eine Leistungsfähigkeit des mindestens einen leistungselektronischen Bauteils reduziert wird, um dieses zu schonen und die durch die Höhenstrahlung hervorgerufene beschleunigte Alterung zu kompensieren. Liegen hingegen (wieder) günstigere Umweltbedingungen vor, so kann die Ansteuerung wieder in entgegengesetzter Weise angepasst werden, indem die Leistungsfähigkeit wieder erhöht wird.

Weitere Merkmale zur Ausgestaltung der leistungselektronischen Anordnung ergeben sich aus der Beschreibung von Ausgestaltungen des Verfahrens. Die Vorteile der leistungselektronischen Anordnung sind hierbei jeweils die gleichen wie bei den Ausgestaltungen des Verfahrens.

Nachfolgend wird die Erfindung anhand bevorzugter Ausführungsbeispiele unter Bezugnahme auf die Figuren näher erläutert. Hierbei zeigen:
- Fig. 1: eine schematische Darstellung zur Verdeutlichung von Ausführungsformen der leistungselektronischen Anordnung;
- Figuren 2a, 2b: schematische Darstellungen zur Verdeutlichung des Verfahrens;
- Fig. 3: ein schematisches Ablaufdiagramm zur Verdeutlichung von Ausführungsformen des Verfahrens zum Betreiben mindestens eines leistungselektronischen Bauteils.

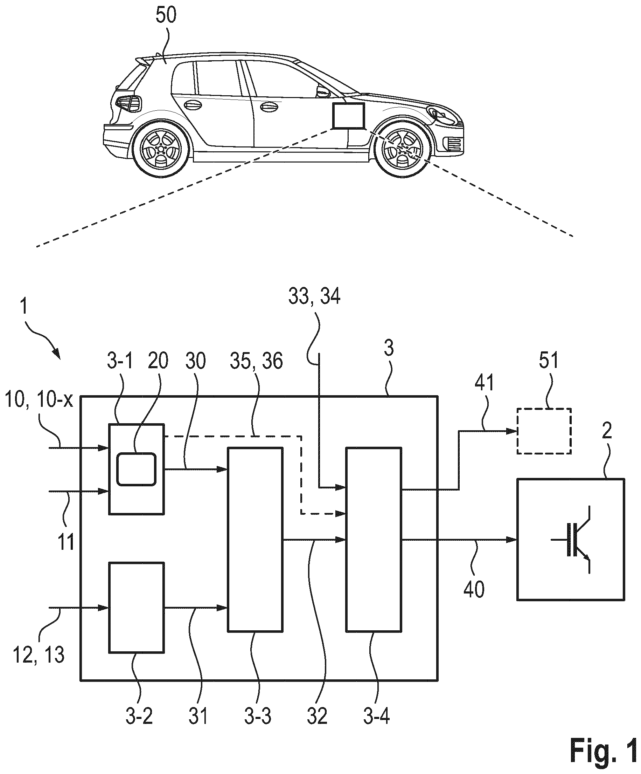

Die Fig. 1 zeigt eine schematische Darstellung einer Ausführungsform der leistungselektronischen Anordnung 1. Die leistungselektronische Anordnung 1 umfasst mindestens ein leistungselektronisches Bauteil 2, insbesondere mindestens einen Leistungshalbleiterschalter, und eine Steuereinrichtung 3. Die Steuereinrichtung 3 ist zum Ansteuern des mindestens einen leistungselektronischen Bauteils 2 eingerichtet. Die leistungselektronische Anordnung 1 ist beispielsweise in einem Fahrzeug 50 angeordnet, wobei das mindestens eine leistungselektronische Bauteil 2 beispielsweise in einem Traktionsstrang des Fahrzeugs 50 als Teil eines Pulswechselrichters zum Speisen einer elektrischen Maschine dient. Die leistungselektronische Anordnung 1 kann auch eine Vielzahl von leistungselektronischen Bauteilen 2, insbesondere eine Vielzahl von Leistungshalbleiterschaltern (z.B. MOSFETs oder IGBTs usw.) umfassen. Nachfolgend wird das Verfahren anhand der leistungselektronischen Anordnung 1 näher beschrieben.

Die Steuereinrichtung 3 ist dazu eingerichtet, ausgehend von Betriebsparametern 10 und/oder Bauteilparametern 11 des mindestens einen leistungselektronischen Bauteils 2 und einem Lebensdauermodell 20 des mindestens einen leistungselektronischen Bauteils 2 einen Ist-Gesundheitszustand 30 des mindestens einen leistungselektronischen Bauteils 2 zu bestimmen. Hierzu weist die Steuereinrichtung 3 beispielsweise ein Modul 3-1 auf. Die Betriebsparameter 10 und/oder Bauteilparameter 11 können mittels hierfür eingerichteter Sensoriken am mindestens einen leistungselektronischen Bauteil 2, im oder am Fahrzeug 50 erfasst werden und/oder beispielsweise von einer übergeordneten Steuerung (nicht gezeigt), insbesondere einer Fahrzeugsteuerung, abgefragt und/oder bereitgestellt werden.

Der Ist-Gesundheitszustand 30 kann ein einzelner Wert sein (z.B. mit einem Wertebereich von 100 % bis 0 % oder 1 bis 0 etc.) Beispielsweise kann vorgesehen sein, einen prozentualen Wert zu bestimmen, der sich auf eine Verschiebung der Thresholdspannung oder des Durchlasswiderstands bezieht, z.B. mit einem Lebensdauerende bei einem vorgegebenen relativen Wert, z.B. bei 15 % Drift, vom Anfangswert, wobei dieser Drift dann 100 % "Lebensdauerverbrauch" entspricht. Ferner kann auch ein mehrdimensionaler Wert vorgesehen sein, bei dem beispielsweise verschiedene Größen jeweils separat berücksichtigt werden (z.B. eine Thresholdspannung, ein Gateoxidzustand, ein Durchlasswiderstand usw.). In einem einfachen Beispiel kann der Ist-Gesundheitszustand 30 anhand eines Durchlasswiderstands zwischen einem Source- und einen Drain-Kontakt abgeschätzt werden. Nach der Inbetriebnahme weist der Durchlasswiderstand beispielsweise einen Wert von 1 mOhm auf, am Ende seiner Lebensdauer hingegen 2 mOhm. Nimmt man einen linearen Verlauf zwischen diesen beiden Extremwerten an, so kann ein Ist-Gesundheitszustand über den Durchlasswiderstand abgeschätzt werden (z.B. bei einem Ist-Wert von 1,5 mOhm erhält man einen Ist-Gesundheitszustand von 0,5 auf einer Skala von 0 bis 1 oder von 50 %, wenn der Gesundheitszustand als Prozentwert ausgedrückt wird).

Ferner bestimmt die Steuereinrichtung 3 ausgehend von einer Betriebsdauer 12 und/oder einer Laufleistung 13 des mindestens einen leistungselektronischen Bauteils 2 einen Soll-Gesundheitszustand 31 des mindestens einen leistungselektronischen Bauteils 2. Hierzu weist die Steuereinrichtung 3 beispielsweise ein Modul 3-2 auf. Der Soll-Gesundheitszustand 31 kann sowohl ein einzelner Wert sein (z.B. mit einem Wertebereich von 100 % bis 0 % oder 1 bis 0 etc.). Beispielsweise kann vorgesehen sein, einen prozentualen Wert zu bestimmen, der sich auf eine Verschiebung der Thresholdspannung oder des Durchlasswiderstands bezieht, z.B. mit einem Lebensdauerende bei einem vorgegebenen relativen Wert, z.B. bei 15 % Drift, vom Anfangswert, wobei dieser Drift dann 100 % "Lebensdauerverbrauch" entspricht. Ferner kann auch ein mehrdimensionaler Wert vorgesehen sein, bei dem beispielsweise verschiedene Größen jeweils separat berücksichtigt werden (z.B. eine Thresholdspannung, ein Gateoxidzustand, ein Durchlasswiderstand usw.).

Weiter vergleicht die Steuereinrichtung 3 den bestimmten Ist-Gesundheitszustand 30 mit dem bestimmten Soll-Gesundheitszustand 31. Insbesondere werden hierbei den jeweiligen Gesundheitszustand kodierende Werte miteinander verglichen. Dies erfolgt beispielsweise in einem Modul 3-3. Sind die Gesundheitszustände 30, 31 mehrdimensional, können die einzelnen Dimensionen beim Vergleich der Gesundheitszustände 30, 31 gewichtet berücksichtigt werden.

Die Steuereinrichtung 3 führt die Ansteuerung des mindestens einen leistungselektronischen Bauteils 2 dann unter Berücksichtigung eines Vergleichsergebnisses 32 durch. Dies erfolgt beispielsweise mittels des Moduls 3-4, welches Teil einer Pulswechselrichteransteuerung sein kann. Die Ansteuerung erfolgt hierbei insbesondere derart, dass ein Kompromiss zwischen einer Lebensdauer bzw. einer Alterung und einer Leistungsfähigkeit des mindestens einen leistungselektronischen Bauteils 2 erreicht wird. Die Steuereinrichtung 3, insbesondere das Modul 3-4, stellt hierzu Steuersignale 40 bereit. Diese Steuersignale 40 können direkt oder indirekt das mindestens leistungselektronische Bauteil 2 ansteuern.

Es kann vorgesehen sein, dass die Ansteuerung des mindestens einen leistungselektronischen Bauteils 2 in dem Fall, in dem ein Wert des bestimmten Ist-Gesundheitszustands 30 kleiner ist als ein Wert des bestimmten Soll-Gesundheitszustands 31, derart geändert wird, dass eine Leistungsfähigkeit des mindestens einen leistungselektronischen Bauteils 2 zugunsten einer Lebensdauer verringert wird.

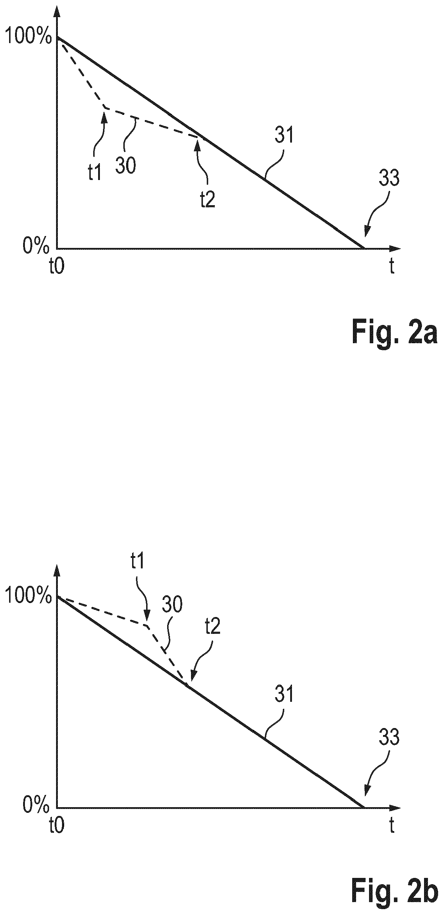

Dies ist schematisch in der Fig. 2a verdeutlicht, welche einen Soll-Gesundheitszustand 30 über die Zeit t von einem Auslieferungszeitpunkt t0 bis zu einer Ziellebensdauer 33 zeigt. Der Ist-Gesundheitszustand 30 fällt stärker ab als der Soll-Gesundheitszustand 31, das heißt, das leistungselektronische Bauteil altert schneller als vorgesehen bzw. erwartet. Zu einem Zeitpunkt t1 wird verfahrensgemäß die Ansteuerung angepasst, wodurch die Alterung verlangsamt wird und sich der Ist-Gesundheitszustand 30 wieder an den Soll-Gesundheitszustand 31 annähert. Zum Zeitpunkt t2 kann die Ansteuerung zugunsten der Leistungsfähigkeit wieder angepasst werden, sodass der Ist-Gesundheitszustand 30 nachfolgend auf der Kurve des Soll-Gesundheitszustands 31 verläuft. Die Fig. 2a ist gegenüber einer realen Anwendung stark vereinfacht und dient nur dazu, das Verfahren zu verdeutlichen. Insbesondere kann ein Kurvenverlauf der Gesundheitszustände 30, 31 anders, insbesondere komplexer, sein.

Es kann hierzu vorgesehen sein, dass Parameter (z.B. eine Frequenz, eine Flankensteilheit, eine Gatespannung usw.) der Ansteuerung angepasst werden, ausgehend von den angepassten Parametern ein zukünftiger Gesundheitszustand mittels des Lebensdauermodells 20 geschätzt wird und ausgehend von dem geschätzten zukünftigen Gesundheitszustand überprüft wird, ob die angepassten Parameter geeignet sind, einen zukünftigen Ist-Gesundheitszustand 30 auf einen zukünftigen Soll-Gesundheitszustand 31 zu bringen.

Es kann ferner vorgesehen sein, dass Kennlinien und/oder Kennfelder zum Anpassen der Parameter der Ansteuerung verwendet werden. Beispielsweise kann eine Kennlinie und/oder ein Kennfeld eine Abhängigkeit von Parametern der Ansteuerung von einer Abweichung zwischen Werten des Ist-Gesundheitszustands 30 und des Soll-Gesundheitszustands 31 beinhalten. Anhand einer gegebenen Abweichung können dann die angepassten Parameter mittels der Kennlinie und/oder des Kennfeldes bestimmt werden. Alternativ oder zusätzlich können auch Verfahren der künstlichen Intelligenz und/oder des Maschinenlernens zum Einsatz kommen.

Es kann vorgesehen sein, dass die Ansteuerung des mindestens einen leistungselektronischen Bauteils 2 in dem Fall, in dem ein Wert des bestimmten Ist-Gesundheitszustands 30 größer als ein Wert des bestimmten Soll-Gesundheitszustands 31 ist, derart geändert wird, dass eine Leistungsfähigkeit des mindestens einen leistungselektronischen Bauteils 2 erhöht wird.

Dies ist schematisch in der Fig. 2b verdeutlicht, welche einen Soll-Gesundheitszustand 30 über die Zeit t von einem Auslieferungszeitpunkt t0 bis zu einer Ziellebensdauer 33 zeigt. Der Ist-Gesundheitszustand 30 fällt langsamer ab als der Soll-Gesundheitszustand 31, das heißt, das leistungselektronische Bauteil altert langsamer als vorgesehen bzw. erwartet. Zu einem Zeitpunkt t1 wird verfahrensgemäß die Ansteuerung angepasst, wodurch die Alterung zugunsten einer erhöhten Leistungsfähigkeit beschleunigt wird, wodurch sich der Ist-Gesundheitszustand 30 wieder an den Soll-Gesundheitszustand 31 annähert. Zum Zeitpunkt t2 kann die Ansteuerung zugunsten der Lebensdauer wieder angepasst werden, sodass der Ist-Gesundheitszustand 30 nachfolgend auf der Kurve des Soll-Gesundheitszustands 31 verläuft. Die Fig. 2b ist gegenüber einer realen Anwendung stark vereinfacht und dient nur dazu, das Verfahren zu verdeutlichen. Insbesondere kann ein Kurvenverlauf der Gesundheitszustände 30, 31 anders, insbesondere komplexer, sein.

Es kann hierzu vorgesehen sein, dass Parameter der Ansteuerung angepasst werden, ausgehend von den angepassten Parametern ein zukünftiger Gesundheitszustand mittels des Lebensdauermodells 20 geschätzt wird und ausgehend von dem geschätzten zukünftigen Gesundheitszustand überprüft wird, ob die angepassten Parameter geeignet sind, einen zukünftigen Ist-Gesundheitszustand 30 auf einen zukünftigen Soll-Gesundheitszustand 31 zu bringen.

Es kann auch hier vorgesehen sein, dass Kennlinien und/oder Kennfelder zum Anpassen der Parameter der Ansteuerung verwendet werden.

Es ist insbesondere vorgesehen, dass das Verringern und/oder Erhöhen der Leistungsfähigkeit unter Berücksichtigung einer vorgegebenen Ziellebensdauer 33 erfolgt. Im oben angegebenen Beispiel kann vorgesehen sein, dass eine bestimmte Betriebsdauer und/oder Laufleistung erreicht werden soll, bis der Widerstand den Wert von 2 mOhm erreicht. Anhand einer bisherigen Entwicklung und einer ausgehend von dem Lebensdauermodell 20 geschätzten zukünftigen Entwicklung des Widerstands können Parameter der Ansteuerung derart angepasst werden, dass die Ziellebensdauer 33 erreicht wird.

Es kann vorgesehen sein, dass das Verringern und/oder Erhöhen der Leistungsfähigkeit unter Berücksichtigung eines Fahrverhaltens 34 mindestens eines Fahrers des Fahrzeugs 50 erfolgt, in dem das mindestens eine leistungselektronische Bauteil 2 verbaut ist. Insbesondere kann hierbei eine Fahrstil berücksichtigt werden. Insbesondere kann vorgesehen sein, ausgehend von dem Fahrverhalten (Fahrstil, Fahrhäufigkeit etc.) des mindestens einen Fahrers eine zukünftige Belastung des mindestens einen leistungselektronischen Bauteils 2 zu schätzen und bei der Ansteuerung, insbesondere bei einem Anpassen von Parametern der Ansteuerung zu berücksichtigen.

Es kann vorgesehen sein, dass mindestens ein Parameter 41 einer zum Kühlen des mindestens einen leistungselektronischen Bauteils 2 eingerichteten Kühleinrichtung 51 unter Berücksichtigung des Vergleichsergebnisses 32 festgelegt und/oder gewählt wird. Dies kann ebenfalls mittels des Moduls 3-4 erfolgen.

Es kann vorgesehen sein, dass mindestens ein Bauteilparameter 11 des mindestens einen leistungselektronischen Bauteils 2 bei einer ersten Inbetriebnahme erfasst und/oder bestimmt wird, wobei die Ansteuerung des mindestens einen leistungselektronischen Bauteils 2 unter Berücksichtigung einer im weiteren Betrieb auftretenden Parameterdrift 35 des mindestens einen erfassten und/oder bestimmten Bauteilparameters 11 erfolgt. Die Parameterdrift 35 kann beispielsweise mittels des Moduls 3-1 bestimmt werden und dem Modul 3-4 zum Anpassen der Ansteuerung zugeführt werden.

Es kann vorgesehen sein, dass mindestens ein Bauteilparameter 11 des mindestens einen leistungselektronischen Bauteils 2 bei einer ersten Inbetriebnahme erfasst und/oder bestimmt wird, wobei die Ansteuerung des mindestens einen leistungselektronischen Bauteils 2 zur Kompensation einer Parameterstreuung 36 unter Berücksichtigung des mindestens einen erfassten und/oder bestimmten Bauteilparameters 11 erfolgt. Die Parameterstreuung 36, beispielsweise in Form einer Differenz zu einem bekannten oder vorgegebenen Mittelwert, kann ebenfalls von dem Modul 3-1 bestimmt werden und dem Modul 3-4 zum Anpassen der Ansteuerung zugeführt werden. Das Modul 3-1 passt die Ansteuerung dann insbesondere derart an, dass das leistungselektronische Bauteil 2 ein Verhalten zeigt, wie man es erwarten würde, wenn der mindestens eine Bauteilparameter 11 des leistungselektronischen Bauteils 2 dem bekannten Mittelwert entsprochen hätte.

Es kann vorgesehen sein, dass die Betriebsparameter 10 eine Umgebungstemperatur 10-1 und/oder eine Höhenstrahlungsbelastung 10-2 und/oder eine Betriebshöhe 10-3 umfassen und/oder dass die Umgebungstemperatur 10-1 und/oder die Höhenstrahlungsbelastung 10-2 und/oder die Betriebshöhe 10-3 im Lebensdauermodell 20 berücksichtigt werden.

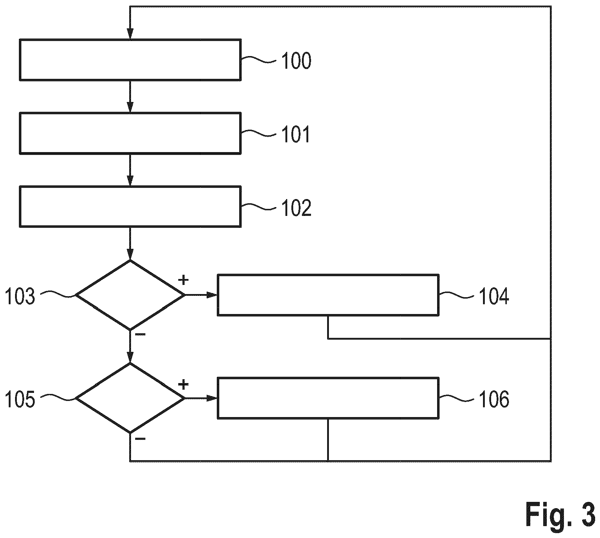

Die Fig. 3 zeigt ein schematisches Ablaufdiagramm zur Verdeutlichung einer Ausführungsform des Verfahrens zum Betreiben mindestens eines leistungselektronischen Bauteils. Das Verfahren wird insbesondere mittels einer leistungselektronischen Anordnung gemäß der in der Fig. 1 gezeigten Ausführungsform durchgeführt.

In einem Verfahrensschritt 100 wird ausgehend von Betriebs- und/oder Bauteilparametern und einem Lebensdauermodell des mindestens einen leistungselektronischen Bauteils ein Ist-Gesundheitszustand des mindestens einen leistungselektronischen Bauteils bestimmt. Das Verfahren kann das Erfassen und/oder Bestimmen der Betriebs- und/oder Bauteilparameter auch umfassen.

In einem Verfahrensschritt 101 wird ausgehend von einer Betriebsdauer und/oder einer Laufleistung des mindestens einen leistungselektronischen Bauteils ein Soll-Gesundheitszustand des mindestens einen leistungselektronischen Bauteils bestimmt.

In einem Verfahrensschritt 102 wird der bestimmte Ist-Gesundheitszustand mit dem bestimmten Soll-Gesundheitszustand verglichen.

In einem Verfahrensschritt 103 wird überprüft, ob ein Wert des bestimmten Ist-Gesundheitszustands kleiner ist als ein Wert des bestimmten Soll-Gesundheitszustands. Ist dies der Fall, so wird die Ansteuerung des mindestens einen leistungselektronischen Bauteils in einem Verfahrensschritt 104 derart geändert, dass eine Leistungsfähigkeit des mindestens einen leistungselektronischen Bauteils zugunsten einer Lebensdauer verringert wird. Anschließend wird wieder zu Verfahrensschritt 100 zurückgekehrt. Ist dies hingegen nicht der Fall, so wird mit Verfahrensschritt 105 fortgefahren.

Im Verfahrensschritt 105 wird überprüft, ob ein Wert des bestimmten Ist-Gesundheitszustands größer als ein Wert des bestimmten Soll-Gesundheitszustands ist. Ist dies der Fall, so wird die Ansteuerung des mindestens einen leistungselektronischen Bauteils in einem Verfahrensschritt 106 derart geändert, dass eine Leistungsfähigkeit des mindestens einen leistungselektronischen Bauteils erhöht wird. Anschließend wird wieder zu Verfahrensschritt 100 zurückgekehrt. Ist dies hingegen nicht der Fall, so wird wieder zu Verfahrensschritt 100 zurückgekehrt.

Es kann vorgesehen sein, dass das Verringern und/oder Erhöhen der Leistungsfähigkeit in den Verfahrensschritten 104 und 106 unter Berücksichtigung einer vorgegebenen Ziellebensdauer erfolgt.

Weitere Ausführungsformen des Verfahrens wurden voranstehend bereits mit Bezug auf die Fig. 1 beschrieben.

### Bezugszeichenliste

- 1: leistungselektronische Anordnung
- 2: leistungselektronisches Bauteil
- 3: Steuereinrichtung
- 3-x: Modul
- 10: Betriebsparameter
- 10-1: Umgebungstemperatur
- 10-2: Höhenstrahlungsbelastung
- 10-3: Betriebshöhe
- 11: Bauteilparameter
- 12: Betriebsdauer
- 13: Laufleistung
- 20: Lebensdauermodell
- 30: Ist-Gesundheitszustand
- 31: Soll-Gesundheitszustand
- 32: Vergleichsergebnis
- 33: Ziellebensdauer
- 34: Fahrverhalten
- 35: Parameterdrift
- 36: Parameterstreuung
- 40: Steuersignal(e)
- 41: Parameter
- 50: Fahrzeug
- 51: Kühleinrichtung
- 100-106: Verfahrensschritte

## Patentansprüche

1. Verfahren zum Betreiben mindestens eines leistungselektronischen Bauteils (2),
wobei ausgehend von Betriebsparametern (10,10-x) und/oder Bauteilparametern (11) und einem Lebensdauermodell (20) des mindestens einen leistungselektronischen Bauteils (2) ein Ist-Gesundheitszustand (30) des mindestens einen leistungselektronischen Bauteils (2) bestimmt wird,
wobei ausgehend von einer Betriebsdauer (12) und/oder einer Laufleistung (13) des mindestens einen leistungselektronischen Bauteils (2) ein Soll-Gesundheitszustand (31) des mindestens einen leistungselektronischen Bauteils (2) bestimmt wird,
wobei der bestimmte Ist-Gesundheitszustand (30) mit dem bestimmten Soll-Gesundheitszustand (31) verglichen wird, und wobei eine Ansteuerung des mindestens einen leistungselektronischen Bauteils (2) unter Berücksichtigung eines Vergleichsergebnisses (32) erfolgt.

2. Verfahren nach Anspruch 1, **dadurch gekennzeichnet, dass** die Ansteuerung des mindestens einen leistungselektronischen Bauteils (2) in dem Fall, in dem ein Wert des bestimmten Ist-Gesundheitszustands (30) kleiner ist als ein Wert des bestimmten Soll-Gesundheitszustands (31), derart geändert wird, dass eine Leistungsfähigkeit des mindestens einen leistungselektronischen Bauteils (2) zugunsten einer Lebensdauer verringert wird.

3. Verfahren nach Anspruch 1 oder 2, **dadurch gekennzeichnet, dass** die Ansteuerung des mindestens einen leistungselektronischen Bauteils (2) in dem Fall, in dem ein Wert des bestimmten Ist-Gesundheitszustands (30) größer als ein Wert des bestimmten Soll-Gesundheitszustands (31) ist, derart geändert wird, dass eine Leistungsfähigkeit des mindestens einen leistungselektronischen Bauteils (2) erhöht wird.

4. Verfahren nach Anspruch 2 oder 3, **dadurch gekennzeichnet, dass** das Verringern und/oder Erhöhen der Leistungsfähigkeit unter Berücksichtigung einer vorgegebenen Ziellebensdauer (33) erfolgt.

5. Verfahren nach einem der vorangegangenen Ansprüche 2 bis 4, **dadurch gekennzeichnet, dass** das Verringern und/oder Erhöhen der Leistungsfähigkeit unter Berücksichtigung eines Fahrverhaltens (34) mindestens eines Fahrers eines Fahrzeugs (50) erfolgt, in dem das mindestens eine leistungselektronische Bauteil (2) verbaut ist.

6. Verfahren nach einem der vorangegangenen Ansprüche, **dadurch gekennzeichnet, dass** mindestens ein Parameter (41) einer zum Kühlen des mindestens einen leistungselektronischen Bauteils (2) eingerichteten Kühleinrichtung (51) unter Berücksichtigung des Vergleichsergebnisses (32) festgelegt und/oder gewählt wird.

7. Verfahren nach einem der vorangegangenen Ansprüche, **dadurch gekennzeichnet, dass** mindestens ein Bauteilparameter (11) des mindestens einen leistungselektronischen Bauteils (2) bei einer ersten Inbetriebnahme erfasst und/oder bestimmt wird, wobei die Ansteuerung des mindestens einen leistungselektronischen Bauteils (2) unter Berücksichtigung einer im weiteren Betrieb auftretenden Parameterdrift (35) des mindestens einen erfassten und/oder bestimmten Bauteilparameters (11) erfolgt.

8. Verfahren nach einem der vorangegangenen Ansprüche, **dadurch gekennzeichnet, dass** mindestens ein Bauteilparameter (11) des mindestens einen leistungselektronischen Bauteils (2) bei einer ersten Inbetriebnahme erfasst und/oder bestimmt wird, wobei die Ansteuerung des mindestens einen leistungselektronischen Bauteils (2) zur Kompensation einer Parameterstreuung (36) unter Berücksichtigung des mindestens einen erfassten und/oder bestimmten Bauteilparameters (11) erfolgt.

9. Verfahren nach einem der vorangegangenen Ansprüche, **dadurch gekennzeichnet, dass** die Betriebsparameter (10,10-x) eine Umgebungstemperatur (10-1) und/oder eine Höhenstrahlungsbelastung (10-2) und/oder eine Betriebshöhe (10-3) umfassen und/oder dass die Umgebungstemperatur (10-1) und/oder die Höhenstrahlungsbelastung (10-2) und/oder die Betriebshöhe (10-3) im Lebensdauermodell (20) berücksichtigt werden.

10. Leistungselektronische Anordnung (1), umfassend:
mindestens ein leistungselektronisches Bauteil (2), und
eine Steuereinrichtung (3), die eingerichtet ist zum Ansteuern des mindestens einen leistungselektronischen Bauteils (2),
wobei die Steuereinrichtung (3) dazu eingerichtet ist, ausgehend von Betriebsparametern (10,10-x) und/oder Bauteilparametern (11) und einem Lebensdauermodell (20) des mindestens einen leistungselektronischen Bauteils (2) einen Ist-Gesundheitszustand (30) des mindestens einen leistungselektronischen Bauteils (2) zu bestimmen, ausgehend von einer Betriebsdauer (12) und/oder einer Laufleistung (13) des mindestens einen leistungselektronischen Bauteils (2) einen Soll-Gesundheitszustand (31) des mindestens einen leistungselektronischen Bauteils (2) zu bestimmen, den bestimmten Ist-Gesundheitszustand (30) mit dem bestimmten Soll-Gesundheitszustand (31) zu vergleichen, und die Ansteuerung des mindestens einen leistungselektronischen Bauteils (2) unter Berücksichtigung eines Vergleichsergebnisses (32) durchzuführen.
